# FASCICULE DE BREVET EUROPEEN

(11) **EP 1 308 631 B1**
(45) Date de publication et mention de la délivrance du brevet: **21.12.2005**
(21) Numéro de dépôt: 02024060.2
(22) Date de dépôt: 28.10.2002
(51) Int. Cl.: F04D 29/58, F04D 29/42, F04D 25/08

(54) **Groupe moto-ventilateur**
Motorlüfter
Motor fan unit

(30) Priorité: 02.11.2001 FR 0114242
(43) Date de publication de la demande: 07.05.2003
(73) Titulaire: VALEO SYSTEMES THERMIQUES, 78321 Le Mesnil Saint Denis (FR)
(72) Inventeur: Talaucher, Stéphane, 78830 Bonnelles (FR); Geroud, Pierre-Arnaud, 78400 Chatou (FR); Boucheret, Bernard, 92230 Gennevilliers (FR)

(56) Documents cités:
- EP-A- 0 501 198
- EP-A- 0 652 375
- FR-A- 2 236 384

## Description

### Arrière-plan de l'invention

L'invention concerne un groupe moto-ventilateur, notamment pour une installation de chauffage et/ou de climatisation, en particulier pour un véhicule automobile.

Pour une telle application, il est connu d'utiliser un groupe moto-ventilateur du type comportant une volute, une turbine logée dans la volute pour engendrer un flux d'air dans celle-ci, un moteur d'entraînement de la turbine, un support pour le moteur formant également capot d'obturation de la volute d'un côté de celle-ci, et un module de commande du moteur permettant de faire varier la vitesse du moteur selon les besoins.

Le document EP-A-652 375 montre un groupe moto-ventilateur 10 comportant une volute 12, une turbine 14 logée dans la volute pour engendrer un flux d'air dans celle-ci, un moteur 16 d'entraînement de la turbine, un support 30 pour le moteur formant également un capot d'obturation de la volute sur un côté de celle-ci, un module 36 de commande du moteur et au moins un radiateur 38 dissipateur de chaleur engendrée par des composants du module de commande et exposé au flux d'air engendré dans la volute, le module de commande 36 étant monté sur le capot support moteur 30 du côté extérieur de celui-ci.

Un problème à résoudre est le refroidissement du module de commande du moteur. Il est connu à cet effet d'associer au module de commande un ou plusieurs radiateurs pour dissiper la chaleur engendrée par les composants électriques et électroniques de ce module. Il a été en particulier proposé d'exposer le ou les radiateurs au flux d'air engendré dans la volute, mais en disposant les radiateurs en sortie de la volute, ce qui impose un éloignement entre des composants du module de commande et le moteur à commander.

De plus, la présence d'ailettes de radiateurs qui pénètrent sur une distance relativement importante dans le flux d'air issu de la volute engendre des perturbations d'écoulement et du bruit.

### Objet et résumé de l'invention

L'invention a pour but de résoudre le problème du refroidissement du module de commande tout en conservant la possibilité de loger le module au plus près du moteur, afin de réduire les liaisons électriques et l'encombrement, tout en permettant un démontage et un remontage aisés du module de commande lorsque cela est nécessaire, et en assurant un refroidissement efficace de celui-ci.

Ce but est atteint grâce à un groupe moto-ventilateur du type défini en tête de la présente description et dans lequel le module de commande est monté sur le capot support moteur du côté extérieur de celui-ci et le ou chaque radiateur dissipateur de chaleur associé au module de commande est au moins en partie engagé à travers au moins une ouverture formée dans le capot support moteur et débouchant latéralement dans la volute.

Ainsi, un refroidissement efficace peut être obtenu par l'exposition du ou des radiateurs du module de commande aux fortes turbulences d'air régnant dans la volute, tout en permettant un démontage et un remontage aisés du module de commande puisque celui-ci, en cas de besoin, peut être extrait du groupe moto-ventilateur sans nécessiter un démontage du capot support moteur.

Avantageusement, le module de commande comporte au moins un radiateur ayant plusieurs parties qui sont engagées à travers des ouvertures séparées de formes correspondantes. La formation de plusieurs ouvertures, plutôt qu'une ouverture unique et nécessairement plus grande, permet de ne pas affecter la rigidité du capot support moteur.

La ou chaque partie de radiateur est engagée dans une ouverture formée avantageusement dans une zone située entre le contour extérieur du capot support moteur et la partie centrale de celui-ci située en regard de la turbine. De la sorte, la ou chaque partie de radiateur fait saillie latéralement dans la volute à l'extérieur du trajet de la turbine.

La distance de pénétration de la ou de chaque partie de radiateur dans la volute n'est donc pas limitée par la nécessité de ne pas interférer avec la turbine.

Toutefois, afin d'éviter la génération de bruits indésirables, cette distance de pénétration peut être relativement réduite, par exemple comprise entre 1 mm et 20 mm, de préférence entre 1 mm et 15 mm.

Lorsque le ou chaque radiateur pénètre au moins en partie faiblement à l'intérieur de la volute, voire affleure pratiquement sur le côté de celle-ci, une surface d'échange avec l'air suffisante peut être présentée en augmentant les dimensions, mesurées dans le plan du côté de la volute, et par là-même les dimensions de la ou des ouvertures formées dans le capot support moteur.

De façon connue, la surface d'échange peut aussi être accrue en munissant le ou chaque radiateur de reliefs de différentes formes, telles que des nervures, par exemple incurvées, ou des picots.

L'invention a aussi pour objet une installation de chauffage et/ou de climatisation comportant un groupe moto-ventilateur tel que défini ci-dessus.

### Brève description des dessins

L'invention sera mieux comprise à la lecture de la description faite ci-après, à titre indicatif mais non limitatif, en référence aux dessins annexés, sur lesquels :
- la figure 1 est une vue très schématique d'une installation de chauffage et climatisation pour véhicule automobile ;
- la figure 2 est une vue en élévation d'un groupe moto-ventilateur selon un mode de réalisation de l'invention ;
- la figure 3 est une vue partielle de côté du groupe moto-ventilateur de la figure 2 ;
- la figure 4 est une vue très schématique en perspective montrant le capot support moteur et la turbine du groupe moto-ventilateur de la figure 2 ;
- la figure 5 est une vue très schématique en perspective et à échelle agrandie montrant le module de commande moteur du groupe moto-ventilateur de la figure 2 ; et
- les figures 6 et 7 sont des vues de détail à échelle agrandie montrant des variantes de réalisation des radiateurs du module de commande moteur dans un groupe moto-ventilateur tel que celui des figures 2 à 5.

### Description détaillée de modes de réalisation de l'invention

Un mode de réalisation de l'invention sera décrit ci-après dans le cadre de l'application à une installation de chauffage et/ou de climatisation de véhicule automobile. Un groupe moto-ventilateur selon l'invention est toutefois utilisable pour d'autres applications requérant la génération d'un flux d'air ou autre gaz.

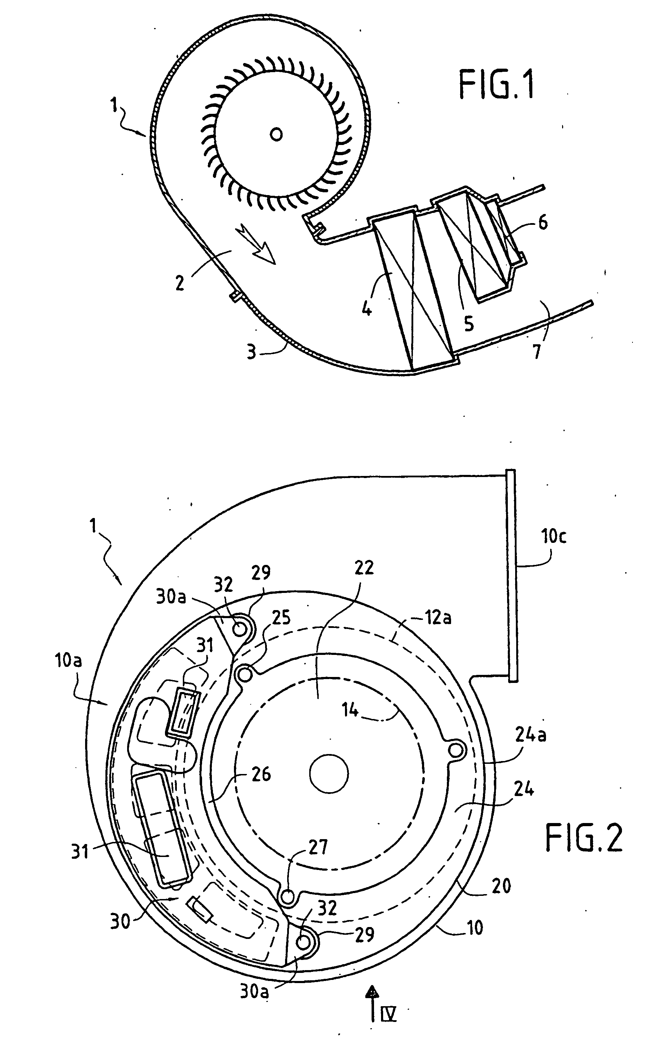

La figure 1 montre très schématiquement une installation de chauffage et climatisation d'air qui comporte, de façon bien connue, un groupe moto-ventilateur 1, ou soufflante, délivrant un flux d'air 2 dans un conduit 3. Dans ce dernier, sont disposés un évaporateur 4 d'un circuit de réfrigération (lorsque la fonction climatisation d'air est présente), un radiateur échangeur de chaleur à liquide 5 parcouru par le liquide de refroidissement du moteur du véhicule et un radiateur électrique d'appoint éventuel 6. En mode climatisation, l'air est dévié dans un passage 7 en dérivation du radiateur 5. En aval des radiateurs 5 et 6, le conduit 3 distribue l'air vers des bouches de sortie dans l'habitacle du véhicule. La distribution et le mixage éventuel de l'air se font à l'aide de volets commandés (non représentés).

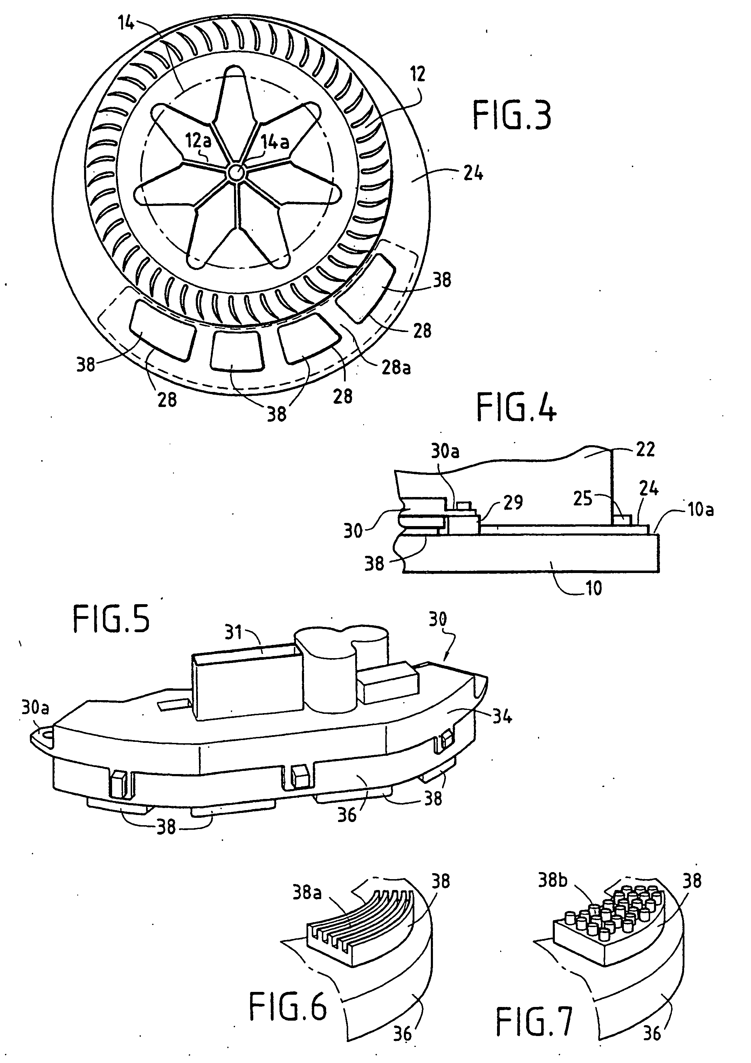

Le groupe moto-ventilateur 1 comporte (figures 1 à 3) une volute 10 à l'intérieur de laquelle est logée une turbine 12. Sur un de ses côtés 10a , la volute présente une ouverture fermée par un capot 20 formant support d'un moteur 14 d'entraînement de la turbine 12. Le moteur 14 (montré schématiquement en trait mixte sur les figures 2 et 3) et la turbine 12 sont coaxiaux. La turbine est montée par des bras radiaux 12a sur l'arbre 14a de sortie du moteur 14. Le support 20 délimite un logement 22 pour le moteur qui fait saillie latéralement sur le côté 10a de la volute. Le côté de la volute opposé au côté 10a présente une ouverture centrale d'admission d'air. L'air aspiré et mis en circulation par la turbine est extrait de la volute 10 par une sortie 10c raccordée au conduit 3.

Dans le groupe moto-ventilateur selon l'invention, un module de commande moteur 30, qui permet d'entraîner le moteur à une vitesse de rotation variable en fonction du débit d'air désiré en sortie de volute, est monté sur le capot support moteur 20, du côté extérieur de celui-ci.

Plus précisément, le module 30 est monté sur une partie d'un rebord 24 du capot support moteur qui entoure l'ouverture du logement moteur 22. Le rebord 24 a un contour 24a circulaire qui s'adapte à l'ouverture latérale formée sur le côté 10a de la volute. L'obturation de cette ouverture est réalisée par exemple par montage du type "quart-de-tour" ou à baïonnette du capot support moteur 20 sur le côté 10a de la volute.

Avantageusement, l'axe du logement moteur 22 (qui est confondu avec l'axe du moteur et de la turbine) est décalé par rapport à celui du contour 24a du capot support moteur. De la sorte, le rebord 24 a une largeur variable et le module 30 est monté dans la zone 26 du rebord 24, de plus grande largeur. Un espace suffisant est ainsi aménagé pour le montage du module 30, tout en limitant l'encombrement total.

Le montage du moteur 14 sur le capot support moteur 20 est assuré par des vis ou des ensembles vis-écrous 27 qui traversent des plots de fixation 25 formés par des parties embouties du rebord 24 dans lesquels sont logées des pattes de montage du moteur.

Le module de commande 30 comprend une plaque de circuit imprimé (non représentée) supportant un ensemble de composants électriques et électroniques et des connecteurs 31 pour recevoir une tension d'alimentation et des signaux de commande de vitesse moteur et pour délivrer l'alimentation nécessaire au moteur. Par souci de simplicité, les liaisons entrantes et sortantes du module de commande et du moteur ne sont pas représentées. La figure 4 montre toutefois que le module de commande 30 est muni d'un capot 34 qui recouvre la plaque de circuit imprimé et les composants portés par celle-ci, et qui est fixé sur un radiateur 36 sur lequel sont disposés la plaque de circuit imprimé et les composants portés par celle-ci.

Le radiateur 36 comporte des parties en saillie telles que des plots ou ailettes 38 à sa face inférieure, les plots ou ailettes 38 sont engagés dans des ouvertures 28 de la partie du rebord 24 sur laquelle le module 30 est fixé. Dans l'exemple illustré, les plots 38 sont à section sensiblement en forme de secteurs d'anneau, les ouvertures 28 ayant des formes correspondantes.

Les ouvertures 28 sont formées dans une zone du rebord 24 située entre le contour 24a et la partie centrale du capot support moteur située en regard de la turbine 12. Ainsi, les ouvertures 28 débouchent latéralement dans la volute 10 à l'extérieur du parcours de la turbine (la limite 12a du parcours de la turbine est indiquée en traits interrompus sur la figure 2).

Bien entendu, le nombre et la forme des plots ou ailettes 38 pourra varier sans sortir du cadre de l'invention. Il peut être envisagé d'engager le radiateur 36, muni ou non de plots ou d'ailettes, à travers une ouverture épousant son pourtour. Toutefois, en raison de sa dimension, une telle ouverture peut risquer d'affecter la rigidité du capot support moteur 20. C'est pourquoi, la réalisation de plusieurs ouvertures 28 de plus petites dimensions à travers lesquelles s'engagent des parties en saillie du radiateur est préférée. En effet, la rigidité du capot support moteur est alors préservée par les bandes de matière 28a formant entretoises qui séparent les ouvertures les unes des autres.

On notera aussi que le module de commande peut être muni de plusieurs radiateurs distincts à sa partie inférieure. Selon la taille de ces radiateurs, ils pourront être engagés en totalité, ou en partie par l'intermédiaire de reliefs ou ailettes formés à leur face inférieure, dans des ouvertures du capot support moteur.

Le module de commande 30 est fixé par exemple au moyen de vis 32 qui passent dans des pattes 30a aux extrémités du module et se vissent dans des plots 29 formés intégralement avec le capot support moteur 20.

Ainsi, en cas de défaillance, le module de commande 30 peut être aisément démonté du groupe moto-ventilateur puisqu'après retrait des vis 32, il peut être extrait sans nécessiter le démontage du capot support moteur. Le remontage d'un module de commande est tout aussi aisé.

Les plots ou ailettes 38 du radiateur qui pénètrent à l'intérieur de la volute 10 se situent à l'extérieur du parcours de la turbine 12, au voisinage de la périphérie de la volute, et ne peuvent interférer avec la turbine lorsque celle-ci est en rotation.

Il est toutefois souhaitable, pour éviter la génération de bruit indésirable, de limiter la pénétration des plots ou ailettes 38 dans la volute. Une distance de pénétration de 1 mm à 20 mm, voire même de 1 mm à 15 mm est préférable. Même dans le cas où les plots ou ailettes 38 affleurent pratiquement sur le côté de la volute, un échange thermique satisfaisant avec l'air peut être réalisé en raison des turbulences régnant dans la volute. En effet, comme le montre la figure 2, la zone de montage du module 30 peut se situer assez nettement en amont de la sortie de la volute, sortie au niveau de laquelle le flux d'air est moins turbulent. La zone 26 du rebord 24 où sont formées les ouvertures 28 a une position angulaire médiane qui est décalée de préférence d'au moins 90° en amont par rapport à la sortie de la volute, ce qui place le module du radiateur dans la zone de plus forte turbulence de la volute et améliore ainsi considérablement son refroidissement.

En dépit d'une faible pénétration dans la volute, les plots ou ailettes 38 peuvent avoir individuellement ou globalement, des dimensions suffisantes, mesurées dans le plan du côté 10a de la volute, pour offrir une grande surface d'échange, les ouvertures 28 étant dimensionnées de façon correspondante.

De façon connue en soi, une augmentation de la surface d'échange peut être obtenue formant des reliefs particuliers sur les plots ou ailettes 38.

La figure 5 montre des plots ou ailettes 38 qui présentent à leur face d'extrémité des nervures 38a de forme incurvée, qui sont sensiblement alignées avec la direction générale d'écoulement de l'air dans la volute afin de limiter les perturbations causées à cet écoulement.

Selon une autre variante montrée par la figure 6, les plots ou ailettes 38 présentent à la face externe des reliefs en forme de picots 38b, disposés par exemple en quinconce.

## Revendications

1. Groupe moto-ventilateur (1) comportant une volute (10), une turbine (12) logée dans la volute pour engendrer un flux d'air dans celle-ci, un moteur (14) d'entraînement de la turbine, un support (20) pour le moteur formant également un capot d'obturation de la volute sur un côté (10a) de celle-ci, et un module (30) de commande du moteur associé à au moins un radiateur (36) dissipateur de chaleur engendrée par des composants du module de commande et exposé au flux d'air engendré dans la volute, **caractérisé en ce que** le module de commande (30) est monté sur le capot support moteur (20) du côté extérieur de celui-ci et le radiateur (36) est au moins en partie engagé à travers au moins une ouverture (28) formée dans le capot support moteur et débouchant latéralement dans la volute.

2. Groupe moto-ventilateur selon la revendication 1, **caractérisé en ce que** le module de commande (30) comporte au moins un radiateur (36) ayant plusieurs parties (38) qui font saillie à une surface externe du radiateur et qui sont engagées dans des ouvertures séparées (28) formées dans le capot support moteur (20).

3. Groupe moto-ventilateur selon l'une quelconque des revendications 1 et 2, **caractérisé en ce que** le ou chaque radiateur (36) est au moins en partie engagé dans au moins une ouverture (28) formée dans une zone (26) située entre un contour extérieur (24a) du capot support moteur et une partie centrale de celui-ci située en regard de la turbine (12).

4. Groupe moto-ventilateur selon la revendication 3, **caractérisé en ce que** la distance de pénétration d'au moins une partie (38) du ou de chaque radiateur à l'intérieur de la volute (10) est comprise entre 1 mm et 20 mm.

5. Groupe moto-ventilateur selon la revendication 4, **caractérisé en ce que** ladite distance de pénétration est comprise entre 1 mm et 15 mm.

6. Groupe moto-ventilateur selon l'une quelconque des revendications 1 à 5, **caractérisé en ce que** le module de commande est monté dans une zone (26) d'un rebord (24) du capot support moteur (20) entourant un logement (22) pour le moteur (14).

7. Groupe moto-ventilateur selon la revendication 6, **caractérisé en ce que** le rebord (24) a un contour circulaire (24a) ayant un centre décalé par rapport à l'axe du moteur (14) et du logement moteur (22) et le module (30) est monté dans la zone (26) du rebord (24) de plus grande largeur.

8. Groupe moto-ventilateur selon l'une quelconque des revendications 1 à 7, **caractérisé en ce que** la zone (26) du rebord (24) a une position angulaire médiane décalée d'au moins 90° en amont par rapport à la sortie de volute.

9. Groupe moto-ventilateur selon l'une quelconque des revendications 1 à 8, **caractérisé en ce que** chaque partie de radiateur (38) engagée à travers une ouverture du capot support moteur porte des reliefs sur sa face d'extrémité.

10. Groupe moto-ventilateur selon la revendication 9, **caractérisé en ce que** lesdits reliefs sont des nervures incurvées (38a).

11. Groupe moto-ventilateur selon la revendication 10, **caractérisé en ce que** lesdites nervures (38a) sont sensiblement alignées avec la direction générale d'écoulement de l'air dans la volute (10).

12. Groupe moto-ventilateur selon la revendication 9, **caractérisé en ce que** lesdits reliefs sont des picots (38b).

13. Installation de chauffage et/ou de climatisation, **caractérisée en ce qu'**elle comporte un groupe moto-ventilateur (1) selon l'une quelconque des revendications 1 à 12 raccordé à un conduit (3) muni d'au moins un dispositif de chauffage (5, 6) ou de refroidissement d'air (4).

## Patentansprüche

1. Lüftersatz (1), der ein Spiralgehäuse (10), eine Turbine (12), die im Spiralgehäuse untergebracht ist, um einen Luftfluss darin zu erzeugen, einen Motor (14) zum Antreiben der Turbine, einen Träger (20) für den Motor, der ebenfalls einen Verschlussdeckel des Spiralgehäuses an einer Seite (10a) davon bildet, und ein Modul (30) zur Steuerung des Motors umfasst, der zumindest einem Heizkörper (36) zugeordnet ist, welcher die Wärme abstrahlt, die von Komponenten des Steuermoduls erzeugt wird und dem Luftfluss ausgesetzt ist, der vom Spiralgehäuse erzeugt wird, **dadurch gekennzeichnet, dass** das Steuermodul (30) auf dem Motorträgerdeckel (20) an der Außenseite von diesem montiert ist und dass der Heizkörper (36) zumindest teilweise durch zumindest eine Öffnung (28) eingeführt ist, die im Motorträgerdeckel gebildet ist und seitlich in das Spiralgehäuse mündet.

2. Lüftersatz nach Anspruch 1, **dadurch gekennzeichnet, dass** das Steuermodul (30) zumindest einen Heizkörper (36) umfasst, der mehrere Teile (38) aufweist, die aus einer externen Fläche des Heizkörpers auskragen und die in getrennte, im Motorträgerdeckel (20) ausgebildete Öffnungen (28) eingeführt sind.

3. Lüftersatz nach einem der Ansprüche 1 und 2, **dadurch gekennzeichnet, dass** der oder jeder Heizkörper (36) zumindest teilweise in zumindest eine Öffnung (28) eingeführt ist, die in einem Bereich(26) gebildet ist, der zwischen einer externen Kontur (24a) des Motorträgerdeckels und einem gegenüber der Turbine (12) liegenden Zentralteil davon liegt.

4. Lüftersatz nach Anspruch 3, **dadurch gekennzeichnet, dass** der Eindringungsabstand von zumindest einem Teil (38) von dem oder von jedem Heizkörper in das Innere des Spiralgehäuses (10) zwischen 1 mm und 20 mm beträgt.

5. Lüftersatz nach Anspruch 4, **dadurch gekennzeichnet, dass** der besagte Eindringungsabstand zwischen 1 mm und 15 mm beträgt.

6. Lüftersatz nach einem der Ansprüche 1 bis 5, **dadurch gekennzeichnet, dass** das Steuermodul in einem Bereich (26) einer Kante (24) des Motorträgerdeckels (20) montiert ist, der eine Lagerung (22) für den Motor (14) umgibt.

7. Lüftersatz nach Anspruch 6, **dadurch gekennzeichnet, dass** das die Kante (24) eine kreisförmige Kontur (24a) aufweist, deren Mitte gegenüber der Achse des Motors (14) und der Motorlagerung (22) verschoben ist und dass das Modul (30) in dem Bereich (26) der Kante (24) montiert ist, die die größte Breite aufweist.

8. Lüftersatz nach einem der Ansprüche 1 bis 7, **dadurch gekennzeichnet, dass** der Bereich (26) der Kante (24) eine mediane Winkelposition aufweist, die gegenüber dem Ausgang des Spiralgehäuses vorher um zumindest 90° verschoben ist.

9. Lüftersatz nach einem der Ansprüche 1 bis 8, **dadurch gekennzeichnet, dass** jeder Teil des Heizkörpers (38), der durch eine Öffnung des Motorträgerdeckels eingeführt ist, Reliefs auf seiner Endfläche aufweist.

10. Lüftersatz nach Anspruch 9, **dadurch gekennzeichnet, dass** die besagten Reliefs einwärts gekrümmte Rippen (38a) sind.

11. Lüftersatz nach Anspruch 10, **dadurch gekennzeichnet, dass** die besagten Rippen (38a) wesentlich auf die allgemeine Abflussrichtung der Luft im Spiralgehäuse (10) ausgerichtet sind.

12. Lüftersatz nach Anspruch 9, **dadurch gekennzeichnet, dass** die besagten Reliefs Stifte (38b) sind.

13. Heiz- und/oder Klimatisierungsanlage, **dadurch gekennzeichnet, dass** sie einen Lüftersatz (1) nach einem der Ansprüche 1 bis 12 umfasst, der an eine Leitung (3) angeschlossen ist, die mit zumindest einer Vorrichtung zum Heizen (5, 6) oder Kühlen von Luft (4) ausgestattet ist.

## Claims

1. Blower unit (1) comprising a scroll (10), a turbine (12) housed in the scroll to create an air flow in it, a turbine drive motor (14), a support (20) for the motor also forming a closing cover for the scroll on one side (10a) thereof, and a motor control module (30) associated with at least one radiator (36) to dissipate heat generated by components of the control module and exposed to the air flow generated in the scroll, **characterised in that** the control module (30) is mounted on the outside of the motor support cover (20) and the radiator (36) is at least partly engaged through at least one opening (28) formed in the motor support cover and opening laterally into the scroll.

2. Blower unit according to claim 1, **characterised in that** the control module (30) comprises at least one radiator (36) with several parts (38) that project from an outer surface of the radiator and that are engaged in separate openings (28) formed in the motor support cover (20).

3. Blower unit according to either of claims 1 or 2, **characterised in that** the radiator or each radiator (36) is at least partly engaged in at least one opening (28) formed in a zone (26) located between an external contour (24a) of the motor support cover and a central part of the motor support cover facing the turbine (12).

4. Blower unit according to claim 3, **characterised in that** the penetration distance of at least one part (38) of the radiator or each radiator inside the scroll (10) is between 1 mm and 20 mm.

5. Blower unit according to claim 4, **characterised in that** said penetration distance is between 1 mm and 15 mm.

6. Blower unit according to any one of claims 1 to 5, **characterised in that** the control module is mounted in a zone (26) of a flange (24) of the motor support cover (20) surrounding a housing (22) for the motor (14).

7. Blower unit according to claim 6, **characterised in that** the flange (24) has a circular contour (24a) with its centre offset from the centre-line of the motor (14) and the motor housing (22), and the module (30) is mounted in the widest part (26) of the flange (24).

8. Blower unit according to any one of claims 1 to 7, **characterised in that** the median angular position of zone (26) of the flange (24) occupies a median angular position offset by at least 90° on the upstream side with respect to the scroll.

9. Blower unit according to any one of claims 1 to 8, **characterised in that** each part of the radiator (38) engaged through the opening of the motor support cover has reliefs on its end surface.

10. Blower unit according to claim 9, **characterised in that** said reliefs are formed by curved ribs (38a).

11. Blower unit according to claim 10, **characterised in that** said ribs (38a) are substantially brought into alignment with the general direction of airflow in the scroll (10).

12. Blower unit according to claim 9, **characterised in that** said reliefs are formed by studs (38b).

13. Heating and / or air conditioning installation, **characterised in that** it comprises a Blower unit (1) according to any one of claims 1 to 12 connected to a duct (3) to which at least one heating device (5, 6) or air cooling device (4) is connected.
